**Europäisches Patentamt**

**European Patent Office**

**Office européen des brevets**

(19)

(11) Veröffentlichungsnummer: **0 192 057 B1**

# (12) EUROPÄISCHE PATENTSCHRIFT

(45) Veröffentlichungstag der Patentschrift: **15.05.91**

(51) Int. Cl.⁵: **G01R 1/067**, G01R 1/073

(21) Anmeldenummer: **86100660.9**

(22) Anmeldetag: **20.01.86**

(54) **Vorrichtung zur Erzeugung eines elektrisch Leitenden Kontaktes an einer isolierten Kabelader.**

(30) Priorität: **22.02.85 DE 3506201**
**16.04.85 DE 3513595**

(43) Veröffentlichungstag der Anmeldung:
**27.08.86 Patentblatt 86/35**

(45) Bekanntmachung des Hinweises auf die
Patenterteilung:
**15.05.91 Patentblatt 91/20**

(84) Benannte Vertragsstaaten:
**DE FR GB IT**

(56) Entgegenhaltungen:
**FR-A- 2 444 940**
**US-A- 2 569 972**
**US-A- 3 864 629**
**US-A- 3 996 511**

(73) Patentinhaber: **Walter Rose GmbH & Co. KG**
**Postfach 29 28**
**W-5800 Hagen 1(DE)**

(72) Erfinder: **Fremgen, Dieter, Dipl.-Ing.**
**Hans Böckler Strasse 46**
**W-5603 Wülfrath(DE)**
Erfinder: **Reitmeyer, Georg, Dipl.-Ing.**
**Echelnteichweg 59**
**W-5860 Iserlohn(DE)**
Erfinder: **Penz, Heinz**
**Kleinestrasse 22**
**W-5800 Hagen 1(DE)**
Erfinder: **Weber, Rolf-Udo**
**Columbusstr. 19**
**W-4330 Mülheim(DE)**

(74) Vertreter: **Patentanwälte Meinke und Dabring-**
**haus Dipl.-Ing. J. Meinke Dipl.-Ing. W. Dab-**
**ringhaus**
**Westenhellweg 67**
**W-4600 Dortmund 1(DE)**

## Beschreibung

Die Erfindung richtet sich auf eine Vorrichtung zur Erzeugung eines elektrisch leitenden Kontaktes an einer isolierten Kabelader, mit wenigstens einer von einer Feder beaufschlagten, in einem Gehäuse geführten, elektrisch leitenden Perforationsnadel zur Durchdringung des Isoliermantels der Kabelader, wobei das eine Ende des Gehäuses mit einer Aufnahme für zu kontaktierende Kabeladern unterschiedlicher Durchmesser ausgerüstet ist und dieses Ende im Bereich der Aufnahme kegel- oder pyramidenförmig ausgebildet ist, wobei die Perforationsnadel von einem im wesentlichen hohlzylinderförmigen, im Gehäuse verschiebbar angeordneten Andruckelement umgeben ist, und mit einer weiteren Feder.

Eine derartige Vorrichtung ist aus der FR-A-2 444 940 bekannt, die mit einem Ansteckclips in Art eines Kugelschreibers od. dgl. versehen ist, wobei dieser Ansteckclips gleichzeitig als Vorschubelement zum Verschieben der Kontaktnadel gegen die Kraft zweier Federn dient. Ist keine Kabelader eingelegt, können die Kontaktnadeln völlig nach außen freiliegend verschoben werden.

Der wesentliche Nachteil der bekannten Lösung besteht darin, daß kein dauerhafter Kontakt vorgenommen werden kann, wenn nicht von Hand der Kontakt aufrechterhalten wird. Bei Neuverdrahtungen, Abzweigungen od. dgl. müssen aber häufig Messungen vorgenommen werden, die es notwendig machen, daß der Benutzer beide Hände frei hat.

Aufgabe der Erfindung ist daher die Schaffung einer Lösung, mit der bei einer Vorrichtung der eingangs bezeichneten Art erreicht wird, daß der Kontakt mit den betroffenen Adern problemlos und sicher hergestellt und aufrechterhalten wird auch dann, wenn der Benutzer die Vorrichtung losläßt, wobei gleichzeitig sichergestellt ist, daß sich die Vorrichtung leicht handhaben läßt.

Mit einer Vorrichtung der eingangs bezeichneten Art wird diese Aufgabe gemäß der Erfindung nach einer Ausführungsvariante dadurch gelöst, daß die Perforationsnadel in Durchdringungsrichtung der Kabelader und das Andruckelement von der weiteren Feder jeweils in Anpreßrichtung auf die Kabelader beaufschlagt sind, wobei im hohlzylindrisch ausgebildeten Gehäuse ein zentrischer Druckstift und ein darauf verschiebbar geführter Rückhubgriff vorgesehen sind, mit dessen Schaft die Perforationsnadel wirkmäßig verbunden ist.

Die Erfindung hat eine Reihe von Vorteilen, die nicht nur in der einfachen Handhabungen liegen, sie bestehen insbesondere auch darin, daß die Andruckkraft der kontaktierenden Perforationsnadel werkseitig vorherbestimmbar und damit dem jeweiligen Einsatzgebiet anpaßbar ist. So kann die Andruckkraft beispielsweise auf 3 Newton eingestellt sein, und zwar durch die Wahl einer entsprechenden Andruckfeder. Diese Kraft wird dann bei jeder weiteren Kontaktierung immer wieder sichergestellt.

An dieser Stelle sei bemerkt, daß es federbelastete Kontaktnadeln bei Zweidrahtklemmen gibt, eine entsprechende Lösung zeigt die US-A-2 569 972. Dort wird über ein verschränktes zangenartiges Element unter Zwischenschaltung einer Feder zwischen den verschränkten Zangenarmen ein Paar von Nadelkissen gegen eingeklemmte Kabeladern gedrückt.

In Ausgestaltung sieht die Erfindung vor, daß innerhalb eines gemeinsamen Gehäuses wenigstens zwei Andruckelemente, zwei Aufnahmen und zwei Perforationsnadeln angeordnet sind. Diese Ausgestaltung der Erfindung macht es möglich, paarweise erreichbare Kabeladern mit nur einer einzigen Vorrichtung zu überbrücken und/oder zwei Kabeladern mit weiteren Leitern zu verbinden.

Eine weitere Ausgestaltung der Erfindung besteht darin, daß die erste Perforationsnadel oder die erste und die zweite Perforationsnadel und das erste Andruckelement oder das erste und das zweite Andruckelement im Gehäuse derart geführt sind, daß bei der Freigabe dieser Vorrichtungsteile in Richtung auf die jeweils eingelegte Kabelader oder eingelegte Kabeladern zunächst das jeweilige Andruckelementund danach die Perforationsnadel bzw. -nadeln in Vortriebsrichtung bewegt werden.

Mit der oben angegebenen Gestaltung der Vorrichtung und der Abfolge der Bewegungsabläufe wird erreicht, daß zunächst die jeweilige Kabelader in der Aufnahme festgelegt wird und danach erst die Durchdringung der Isolierung erfolgt, so daß Fehlkontaktierungen oder etwa eine Verletzung von üblicherweise schräg in den Aufnahmen angeordneten Kabeladern vermieden werden.

Zur Handhabungserleichterung ist in weiterer Ausgestaltung vorgesehen, daß auf dem ortsfesten, zentrischen Druckstift innerhalb des Gehäuses der Rückhubgriff verschiebbar geführt ist, wobei es vorteilhaft sein kann, wenn die die Kontaktierung zwischen Perforationsnadel und dem Leiter der Kabelader kenntlich machende Anzeigeeinheit als eine am Rückhubgriff angeordnete Leuchtdiode ausgebildet ist.

Für einen Benutzer ist es nämlich von Bedeutung erkennen zu können, ob nach Anbringung der Vorrichtung die Perforationsnadel einen Kontakt mit der Kabelader, d.h. mit dem Leiter der Kabelader wirklich zustande gebracht hat oder ob es zu einer Fehlkontaktierung kommt. Diesem Zweck dient eine derartige erfindungsgemäße Anzeigeeinheit.

Nach einer Ausgestaltung in dieser Variante ist vorgesehen, daß die beiden Aufnahmen für zwei Kabeladern in Längsrichtung des Gehäuses hintereinander versetzt angeordnet sind. Dieser Versatz erleichtert das Einführen der Vorrichtung in Bündeln von Kabeladern, insbesondere da zunächst nicht die gesamte Trennkraft zwischen benachbarten Kabeladern an gleich zwei Stellen aufgebracht werden muß, sondern zunächst wird das Eindringen der Vorrichtung an einer Stelle ermöglicht und dann daraufhin an der anderen.

Die Erfindung sieht auch vor, daß die zwei Andrückelemente von individuell zugeordneten Andrückfedern beaufschlagt sind, während die beiden Perforationsnadeln von einer einen gemeinsamen Druckstift beaufschlagenden Feder beaufschlagt werden.

Natürlich kann diese Gestaltung auch so getroffen sein, daß jede Perforationsnadel mit einer individuellen Andruckfeder ausgerüstet ist. Die Zusammenfassung läßt aber eine wirtschaftlichere Herstellung zu.

Eine weitere Lösung der Aufgabe ist durch die Maßnahmen gemäß Anspruch 8 gegeben.

Durch diese Lösung wird weiterhin vermieden, daß bei der Betätigung der Vorrichtung unerwünschte Kräfte in Axialrichtung derselben auf die in der Aufnahme der Vorrichtung befindliche Kabelader bzw. die von der Gehäusespitze kontaktierten sonstigen Kabeladern des betreffenden Kabels, wie etwa bei einem unbeabsichtigten Hochreißen des Kabelstranges oder der Kabelader, ausgeübt werden. Außerdem ist es nicht mehr notwendig, das mit der Perforationsspitze elektrisch leitend verbundene Kontaktkabel seitlich aus der Vorrichtung herauszuführen, was in manchen Fällen raummäßig ungünstig ist und zudem Beschädigungs- bzw. Bruchgefahren nach einer bestimmten Gebrauchszeit für das Kontaktkabel mit sich bringt.

Eine besonders einfache Ausgestaltung erhält man dabei, wenn die radial kompressiblen Teile von zwei diametral am Gehäuse angeordneten Klemmbacken mit konischen Klemmflächen gebildet sind, die mit entsprechenden konischen Flächen an dem Druckkolben im Sinne einer Axialverschiebung des letzteren zusammenwirken.

Wie erkennbar ist, kann durch eine derartige Ausgestaltung die Vorrichtung durch einfaches Zusammendrücken der radial kompressiblen Teile, vorzugsweise von diametral angeordneten Klemmbacken mittels Daumen- und Zeigefinger betätigt werden, wobei die Betätigungskräfte in radialer Richtung aufgebracht werden, so daß eine Axialverschiebung mit damit verbundener Beschädigungsgefahr für die mit der Vorrichtung zusammenwirkenden Kabeladern nicht zu befürchten ist.

In Weiterbildung dieser erfindungsgemäßen Variante kann dann der mit der Perforationsnadel verbundene, gegenüber dem Andrückelement gleitbar angeordnete Druckkolben mit einem axial gerichteten Anschluß für ein Kontaktkabel versehen sein, d.h. das Kontaktkabel kann sich in Axialrichtung von der Vorrichtung fort erstrecken, so daß rechtwinklige Abbiegungen mit dadurch bedingten Beschädigungsgefahren für das Kontaktkabel vermieden sind und außerdem eine raumsparende Führung des Kontaktkabels gegeben ist. Durch den Ersatz des Druckstiftes und des Rückhubgriffes durch die radial kompressiblen Teile baut die erfindungsgemäße Vorrichtung auch wesentlich kürzer, weil axiale Verschiebungswege zwischen den vorgenannten Teilen entfallen.

Die Verkürzung der Gesamtvorrichtung kann noch weiter dadurch gefördert werden, daß der Druckkolben eine zylindrische Hülse aufweist, zwischen welcher und dem zentrischen Teil des Druckkolbens das Andrückelement in Grenzen axial verschieblich angeordnet ist.

In Fortbildung kann dabei zwischen einer Ringschulter des Gehäuses und einer nach außen weisenden Ringschulter der zylindrischen Hülse eine Spiraldruckfeder und zwischen einer Ringschulter des Druckkolbens und einer Ringschulter des Andrückelementes die als Spiraldruckfeder ausgebildete weitere Feder angeordnet sein.

Schließlich ist es in Ausgestaltung der erfindungsgemäßen Variante besonders vorteilhaft, wenn zwischen Druckkolben und Perforationsnadel die erste Feder angeordnet ist, die eine nur von ihrer Stärke abhängige Perforationskraft auf die zu kontaktierende Kabelader ausübt. Dadurch wird gewährleistet, daß zunächst das Andrücken und Fixieren der Kabelader mit immer gleichbleibender, nur von der Stärke der zweiten Feder abhängiger Andrückkraft erfolgt und nachfolgend, d.h. nach dem Fixieren der Kabelader durch das Andrückelement, die auf die Isolierung der Kabelader ausgeübtePerforationskraft unabhängig von der Stärke der jeweiligen Kabelader nur von der Federkennlinie der dritten Feder abhängig ist.

Die Erfindung ist nachfolgend anhand der Zeichnungen beispielsweise näher erläutert. Diese zeigt in

| | |
|---|---|
| Fig. 1 bis 3 | ein Ausführungsbeispiel der Erfindung jeweils geschnitten in unterschiedlichen Arbeitspositionen, |
| Fig. 4 | ein abgewandeltes Beispiel der Erfindung in der gleichen Darstellung der Fig. 1. |
| Fig. 5 | einen Längsschnitt durch ein weiteres Ausführungsbeispiel der Erfindung in unbetätigter Stellung, |
| Fig. 6 | die Vorrichtung gemäß Fig. 5 mit zurückgezogenem Andrückelement und zurückgezogener Perforationsnadel und bereits in der Aufnahme der Vorrichtung befindlicher Kabelader und in |

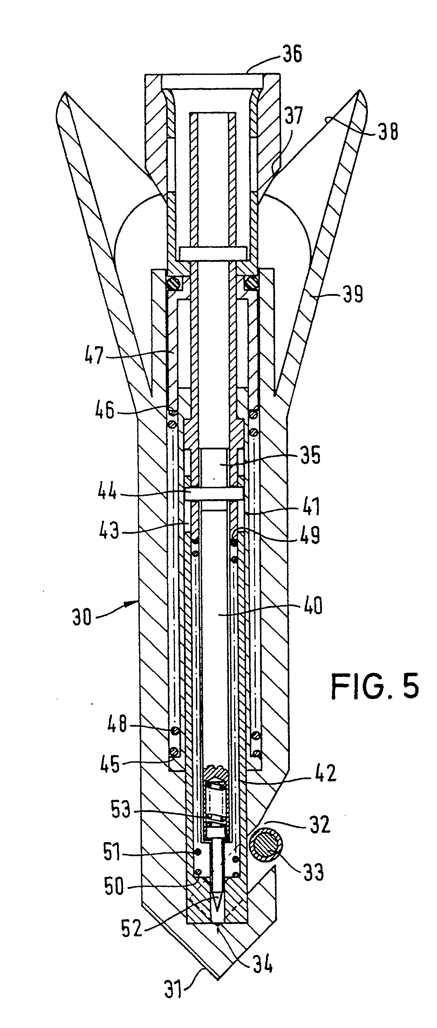

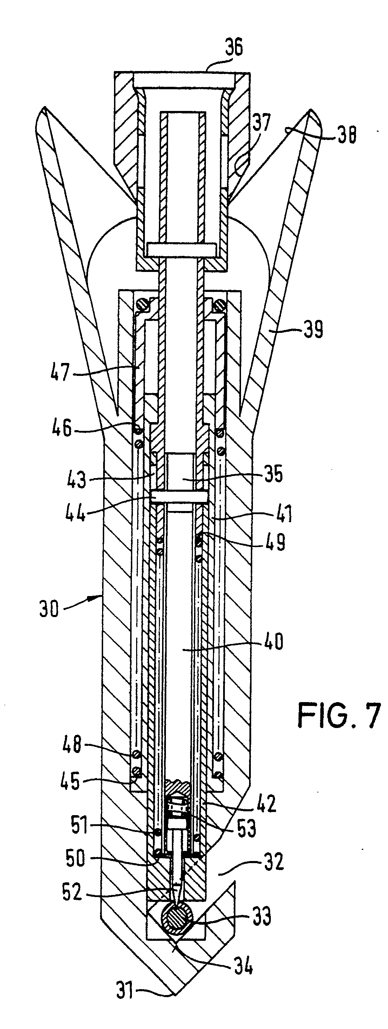

Fig. 7 die Vorrichtung gemäß Fig. 5 in betätigter Stellung, d.h. mit gegen die Kabelader drückendem Andrückelement und in den Kabelmantel der Kabelader eingestochener Perforationsnadel.

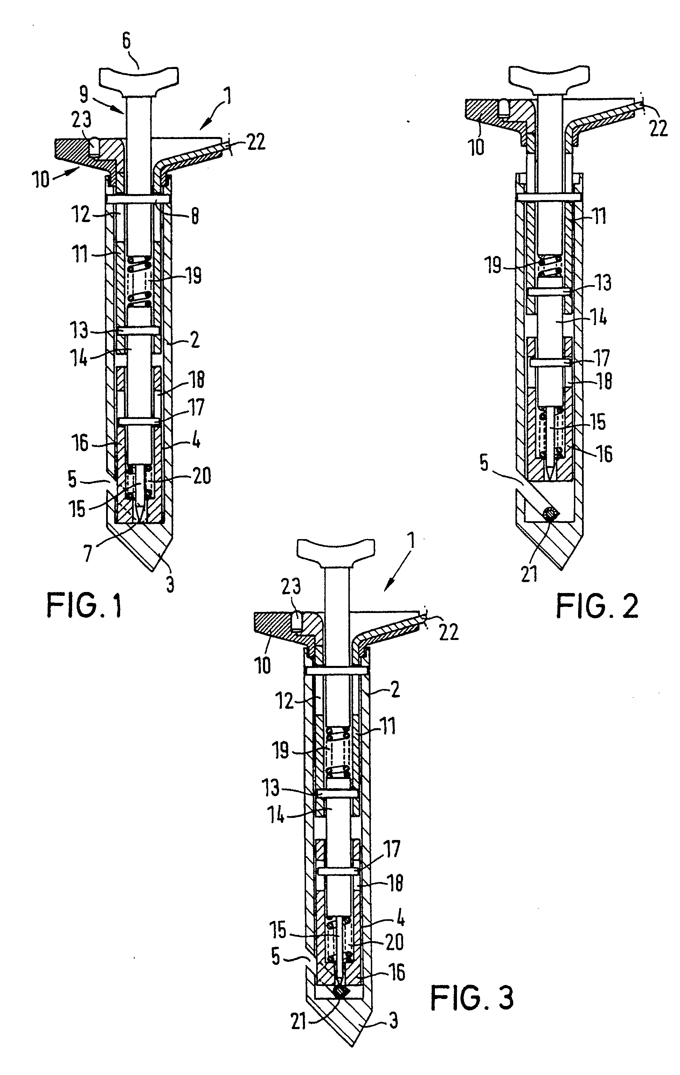

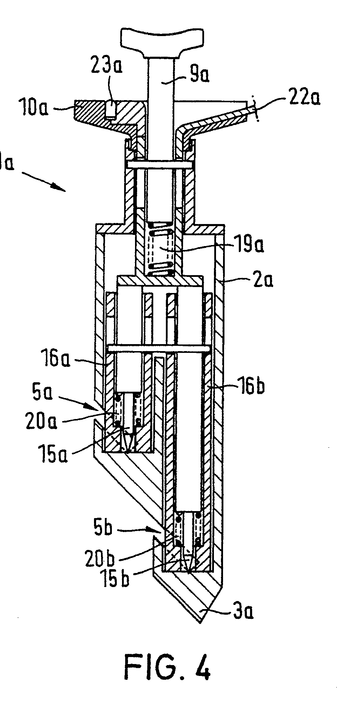

Ist in Fig. 1 bis 3 die Vorrichtung allgemein mit 1 bezeichnet, so trägt die Vorrichtung beim abgewandelten Ausführungsbeispiel gemäß Fig. 4 die allgemeine Bezugsziffer 1a. Im übrigen sind in Fig. 4 alle diejenigen Elemente mit der gleichen Bezugsziffer versehen, wie beim Ausführungsbeispiel nach Fig. 1 allerdings mit einem zusätzlichen "a" bzw. "b".

Wie in Fig. 1 erkennbar, weist die Vorrichtung 1 ein Gehäuse 2 auf, welches im wesentlichen hohlzylindrisch ausgebildet ist. Das Gehäuse 2 ist an einem Ende mit einer kegelförmigen Spitze 3 ausgerüstet. Im Bereich der Spitze 3 endet die Innenbohrung 4 ebenso, wie ein seitlich eingebrachter, in Richtung der Spitze 3 geneigter schräger Schlitz 5, der in der Mittelachse 6, ein Prisma 7 bildend, endet.

Am oberen, der Spitze 3 abgewandten Ende weist das Gehäuse 2 einen zentrischen, über einen Stift 8 ortsfest gehaltenen Druckstift 9 auf.

Auf dem Druckstift 9 und innerhalb der Bohrung 4 des Gehäuses 2 ist ein Rückhubgriff 10 geführt, und zwar mit einem hohlzylinderförmig ausgebildeten Schaft 11. Der Schaft 11 weist im Bereich des Haltestiftes 8 eine Langlochführung 12 auf, die einen Rückhub des Rückhubgriffes aus der in Fig. 1 wiedergegebenen Stellung in die in Fig. 2 wiedergegebene Stellung ermöglicht.

An seinem im Inneren des Gehäuses 2 geführten Ende des Schaftes 11 weist dieser ebenfalls einen Haltestift 13 auf, mit dem ein Druckkolben 14 befestigt ist, dessen Durchmesser im wesentlichen demjenigen des Druckstiftes 6 entspricht. Das in Richtung der kegelförmigen Spitze 3 weisende untere Ende des Kolbens 14 trägt ggf. einstückig oder damit fest verbunden eine Perforationsnadel 15.

Umgeben ist der Kolben 14 und die Perforationsnadel 15 von einem zylindrisch ausgebildeten Andrückelement 16, dessen der kegelförmigen Spitze 3 zugewandtes Ende mit einer Durchtrittsöffnung für die Perforationsnadel 15 in einer Sackbohrung versehen ist. Das Andrückelement 16 hat im wesentlichen die gleichen Durchmesserausbildungen wie der Schaft 11 des Rückhubgriffes 10.

An dem in Richtung des Rückhubgriffes weisenden Ende ist das Andrückelement 16 am Kolben 14 über einen Führungsstift 17 in Langlöchern 18 geführt.

Wie sich aus den Figuren ergibt, ist zwischen dem ortsfesten unteren Ende des Druckstiftes 6 und dem oberen Ende des Kolbens 14 eine Feder 19 vorgesehen, über die die Anpreßkraft auf die mit dem Kolben 14 wirkmäßig verbundene Perforationsnadel 15 aufgebracht wird.

Dem gegenüber ist die Perforationsnadel 15 von einer weiteren Feder umgeben, die mit 20 bezeichnet ist und sich innerhalb der Sackbohrung im Inneren des Andrückelementes 16 einerseits und an einer Schulter am Kolben 14 andererseits abstützt.

Die Wirkungsweise der Vorrichtung ist die folgende:

Wird beabsichtigt, eine Kabelader, die in den Fig. 2 und 3 mit 21 bezeichnet ist, zu kontaktieren, so wird die Vorrichtung 1 mit Hilfe der kegelförmigen Spitze 3 in ein Bündel von Kabeladern eingeführt, was zunächst nicht näher dargestellt ist.

Ist die zu manipulierende Kabelader 21 gefunden, wird diese in den Schlitz 5 eingeführt und durch Rückhub der Vorrichtung 1 bis in das untere Ende dieses Schlitzes in die in Fig. 2 wiedergegebene Stellung gebracht. Durch die prismenförmige Ausbildung kann hier eine Reihe von Kabeladern mit unterschiedlichen Durchmessen jeweils eingeführt werden, ohne daß die Funktionsweise der Vorrichtung dadurch behindert würde. Bei diesem Vorgang ist der Rückhubgriff 10 zurückgezogen, d. h. in der in der Fig. 2 wiedergegebenen oberen Stellung, womit über den Stift 13 der Kolben 14 und den Stift 17 auch das Andrückelement 16 zurückgezogen wurden.

Bei diesem Rückhub des Rückhubgriffes 10 wurde nicht nur das Andrückelement 16 zurückgezogen, sondern in gleicher Weise die Perforationsnadel 15. Die Andrückfeder 19 für die Perforationsnadel 15 wurde dabei komprimiert, wie sich dies besonders gut aus Fig. 2 ergibt. Wird nunmehr der Rückhubgriff 10 losgelassen, bewegen sich die Elemente auf die Kabelader 21 zu, wobei die Kraft der Andrückfedern 19 und 20 und die über die Langlochführungen 12 und 18 zurückzulegenden Wege so getroffen sind, daß sich zunächst das Andrückelement 16, wie in Fig. 3 dargestellt auf der Kabelader 21 abstützt und danach die Perforationsnadel 15 die Isolierung durchbohrt und mit dem Innenleiter einen Kontakt bildet.

Die Perforationsnadel 15 ist elektrisch leitend mit einem oben aus der Vorrichtung 1 herausgeführten Kontaktdraht 22 verbunden. Über diesen Kontaktdraht 22 wird dann die Verbindung mit einer anderen Kabelader 21 hergestellt. Zweckmäßig ist am anderen Ende des Kontaktdrahtes 22 ebenfalls eine Vorrichtung nach der Erfindung angebracht, mit der dann die Verbindung hergestellt wird.

Um erkennen zu können, ob die Kontaktierung stattgefunden hat, ist im Rückhubgriff 10 eine Leuchtdiode 23 untergebracht, die bei Kontaktierung mit dem elektrischen Leiter der Kabelader 21 aufleuchtet und damit die Kontaktierung für den Benutzer deutlich wird.

Wie bereits eingangs der Beschreibung ausgeführt, sind beim Ausführungsbeispiel nach Fig. 4 gleiche Bauteile mit gleichen Bezugzeichen versehen, ergänzt durch ein "a" bzw. "b". Hier seien nur die wesentlichen Unterschiede und Änderungen gegenüber dem Ausführungsbeispiel nach Fig. 1 dargestellt:

Die Vorrichtung 1a ist mit zwei Einführungsschlitzen 5a und 5b ausgerüstet, in die zwei Kabeladern eingeführt werden können. Damit sind auch zwei Perforationsnadeln 15a, 15b, zwei Andrückelemente 16a, 16b aber im Ausführungsbeispiel nur ein Druckstift 9a mit einer Anpreßfeder 19a vorgesehen. Der Rückhubgriff 10a, das Ableitungskabel 22a, die Leuchtdiode 23a einschließlich der wesentlichen Gestaltung des Gehäuses 2a entsprechen im Prinzip der Ausgestaltung nach Fig. 1, die Wirkungsweise ist die gleiche.

Durch Rückhub des entsprechenden Griffes 10a werden sowohl die Andrückelemente 16a, 16b als auch die Perforationsnadeln 15a, 15b aus den Einführschlitzen 5a bzw. 5b herausgehoben, die Kabeladern können eingeführt werden, nach Lösen des Rückhubgriffes 10a werden die Adern dann gehalten und die Perforationsnadeln können die Isolierung durchdringen.

Die in den Fig. 5 bis 7 wiedergegebene Variante der Erfindung zeigt eine Vorrichtung mit einem hohlzylindrisch ausgebildeten Gehäuse 30, das an seinem einen Ende eine kegelförmige Spitze 31 sowie eine Aufnahme 32 für eine zu kontaktierende Kabelader 33 aufweist, wobei die Aufnahme wie bereits weiter oben beschrieben, ausgebildet ist, d.h. einen in Richtung der Spitze 31 geneigten schrägen Schlitz aufweist, der in der Längsmittelachse des Gehäuses 30, ein Prisma 34 bildend, endet.

Im Gehäuse 30 ist eine Blindbohrung mit unterschiedlichen Durchmesserbereichen ausgebildet und in dieser Blindbohrung ist ein insgesamt mit 35 bezeichneter Druckkolben axial verschieblich angeordnet, dessen der Spitze 31 abgewandtes Ende 36 sich aus dem Gehäuse 30 herauserstreckt und mit zwei diametral einander gegenüberliegenden Keilflächen 37 versehen ist. Mit diesen Keilflächen 37 wirken gegenüberliegende Keilflächen 38 des Gehäuses 30 zusammen, die an zwei federnd am Gehäuse 30 ausgebildeten Klemmbacken 39 vorgesehen sind. Der Druckkolben 35 besteht aus fertigungstechnischen Gründen aus mehreren Teilen, nämlich einem zentrischen Teil 40 und einer mit Abstand davon angeordneten zylindrischen Hülse 41, zwischen welcher und dem zentrischen Teil 40 ein Andrückelement 42 axial verschieblich ist, und zwar in den Grenzen, die durch Schlitze 43 in dem Andrückelement und einem diese durchsetzenden Stift 44 zwischen dem zentrischen Teil 40 und der zylindrischen Hülse 41 definiert sind.

Zwischen einer nach außen gerichteten Ringschulter 45 der zylindrischen Hülse 41 und einer Ringschulter 46 eines hülsenförmigen Gehäuseteils 47 ist eine Spiraldruckfeder 48 angeordnet, welche den gesamten Druckkolben 35 in Richtung auf die Spitze 31 zu beaufschlagt, d.h. den Druckkolben 35 in die Blindbohrung des Gehäuses 30 zu drücken sucht. Zwischen einer Ringschulter 49 des Druckkolbens 35 und einer Ringschulter 50 des Andrückelementes 42 ist eine zweite Spiraldruckfeder 51 angeordnet, welche Druckkolben 35 und Andrückelement 42 auseinanderzudrücken sucht, in den Grenzen, die durch das Zusammenwirken von Schlitzen 43 und Stift 44 definiert sind.

In dem der Spitze 31 zugewandten Ende des zentrischen Teils 40 des Druckkolbens 35 ist eine Perforationsnadel 52 gegen die Wirkung einer dritten Spiraldruckfeder 53 axial verschieblich angeordnet.

Die Wirkungsweise der Vorrichtung ist wie folgt :

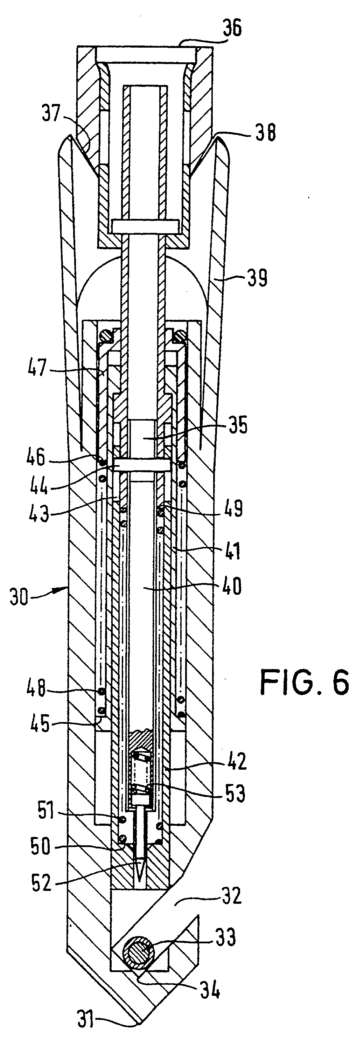

In der in Fig. 5 wiedergegebenen unbetätigten Stellung wird das Gehäuse mit seiner kegelförmigen Spitze 31 in ein Bündel von Kabeladern eingeführt und darauf eine zu manipulierende bzw. zu kontaktierende Kabelader 33 in den Anfangsbereich des Schlitzes 32 eingeführt (s. Fig. 5). Daraufhin werden die beiden Gehäuseklemmbacken 39 mit den konischen Flächen 38 radial zusammengedrückt, worauf durch Zusammenwirken mit den konischen Flächen 37 am oberen Ende 36 des Druckkolbens 35 dieser gegen die Wirkung der Feder 48 axial aus dem Gehäuse heraus verschoben wird, und zwar unter Mitnahme auch des Andrückelements 42 infolge der Schlitz-Stift-Verbindung 43-44. Dabei rutscht die in den Schlitz 32 eingeführte Kabelader 33 bis zum Ende des Schlitzes 32, wo sie durch das Prisma 34 zentriert wird, wie dies Fig. 6 zeigt.

Daraufhin wird der Druck auf die Gehäuseklemmbacken 39 mit den konischen Klemmflächen 38 aufgehoben, wodurch sich der Druckkolben 35 mit dem Andrückelement 42 unter der Wirkung der Feder 48 wieder in das Gehäuse 30 hineinbewegt, wobei sich zunächst das Andrückelement 42 auf die Kabelader 33 aufsetzt und diese dadurch in genau vorbestimmter Lage fixiert, bevor durch weiteres Absenken des Druckkolbens 35 die Perforationsnadel 52 mit der Isolierung der Kabelader 33 in Kontakt kommt und diese nur unter der Druckwirkung der dritten Feder 53 mit durch die Bemessung dieser dritten Feder genau dosierter Kraft durchstößt, bis elektrischer Kontakt mit dem leitenden Kern der Kabelader 33 hergestellt ist. Wie erkennbar ist, kann aufgrund der beschriebenen Ausbildung in nicht näher dargestellter Weise an dem oberen Ende 36 des Druckkolbens 35 ein Anschluß für ein Kontaktkabel derart ausgebildet sein, daß dieses Kontaktkabel in axialer Richtung aus der Vorrichtung herausgeführt wird, z.B. um mit einer anderen Kabelader, vorzugsweise unter Verwendung einer weiteren Vorrichtung der vorbeschriebenen Art, verbunden zu werden. Ferner ist erkennbar, daß bei der Betätigung dieser abgeänderten Ausführungsform der Erfindung keinerlei axial gerichteten Kräfte von der Vorrichtung auf die zu kontaktierende Kabelader und die umgebenden Kabeladern ausgeübt werden, so daß eine schonende Behandlung derselben bei der Manipulation gewährleistet ist. Außerdem ist erkennbar, daß diese Ausführungsform insgesamt sehr kurz baut, weil die erforderlichen axialen Verschiebungswege klein sein können und alle zueinander verschieblichen Teile, einschließlich der Betätigungsfedern, konzentrisch zueinander angeordnet sind.

Natürlich sind die beschriebenen Ausführungsbeispiele der Erfindung noch in vielfacher Hinsicht abzuändern ohne den Grundgedanken zu verlassen. Die Erfindung ist insbesondere nicht auf die spezielle Form der Perforationsnadel und der Führung im Gehäuse beschränkt. Hier können auch andere Gestaltungen vorgesehen sein. In dem Ausführungsbeispiel nach Fig. 4 können auch eine Mehrzahl von etwa kammartig nebeneinander angeordneten Einzelvorrichtungen zu Einheiten zusammengefaßt werden, was sich insbesondere dann anbietet, wenn regelmäßig eine im wesentlichen vorbestimmte Anzahl von Kabeladern miteinander oder mit anderen Kabeladern kontaktiert werden sollen u. dgl. mehr.

Ferner können nach dem Ausführungsbeispiel nach Fig. 5 bis 7 anstelle der diametral angeordneten Klemmbacken auch andere radial kompressible Teile zwischen Gehäuse und Druckkolben vorgesehen sein, beispielsweise zwei einander gegenüberliegende Scherenlenker.

Kombinationen der vorbeschriebenen Ausführungsbeispiele sind möglich, insbesondere können auch bei einer Ausbildung nach Fig. 5 innerhalb eines gemeinsamen Gehäuses wenigstens zwei Andrückelemente, zwei Aufnahmen und zwei Perforationsnadeln angeordnet sein u. dgl. mehr.

**Ansprüche**

1. Vorrichtung (1) zur Erzeugung eines elektrisch leitenden Kontaktes an einer isolierten Kabelader (21), mit einer von einer ersten Feder (19) beaufschlagten, in einem Gehäuse (2) geführten, elektrisch leitenden ersten Perforationsnadel (15) zur Durchdringung des Isoliermantels der Kabelader (21), wobei das eine Ende (3) des Gehäuses (2) mit einer ersten Aufnahme (5) für zu kontaktierende Kabeladern unterschiedlicher Durchmesser ausgerüstet ist und dieses Ende (3) im Bereich der ersten Aufnahme (5) kegel- oder pyramidenförmig ausgebildet ist, wobei die erste Perforationsnadel (15) von einem im wesentlichen hohlzylinderförmigen, im Gehäuse (2) verschiebbar angeordneten ersten Andruckelement (16) umgeben ist, und mit einer weiteren Feder (20), dadurch gekennzeichnet, daß die erste Perforationsnadel (15) in Durchdringungsrichtung der Kabelader (21) und das erste Andruckelement (16) von der weiteren Feder (20) jeweils in Anpreßrichtung auf die Kabelader (21) beaufschlagt sind, wobei im hohlzylindrisch ausgebildeten Gehäuse (2) ein zentrischer Druckstift (9) und ein darauf verschiebbar geführter Rückhubgriff (10) vorgesehen sind, mit dessen Schaft (11) die erste Perforationsnadel (15) wirkmäßig verbunden ist.

2. Vorrichtung nach Anspruch 1, dadurch gekennzeichnet, daß innerhalb eines gemeinsamen Gehäuses (2a) wenigstens zwei Andruckelemente (16a,16b), zwei Aufnahmen (5a,5b) und zwei Perforationsnadeln (15a,15b) angeordnet sind.

3. Vorrichtung nach Anspruch 1 oder 2, dadurch gekennzeichnet, daß die erste Perforationsnadel (15) oder die erste und die zweite Perforationsnadel (15a,15b) und das erste Andruckelement (16) oder das erste und das zweite Andruckelement (16,42;16a,16b) im Gehäuse (20) derart geführt sind, daß bei der Freigabe dieser Vorrichtungsteile in Richtung auf die jeweils eingelegte Kabelader (21) oder eingelegte Kabeladern (21) zunächst das jeweilige Andruckelement und danach die Perforationsnadel bzw. -nadeln in Vortriebsrichtung bewegt werden.

4. Vorrichtung nach Anspruch 1, 2 oder 3, dadurch gekennzeichnet, daß auf dem ortsfesten, zentrischen Druckstift (9) innerhalb des Gehäuses (2) der Rückhubgriff (10) verschiebbar geführt ist.

5. Vorrichtung nach Anspruch 1 oder einem der folgenden, dadurch gekennzeichnet, daß die die Kontaktierung zwischen erste Perforationsnadel (15) und dem Leiter der Kabelader (21) kenntlich machende Anzeigeeinheitals eine am Rückhubgriff (10) angeordnete Leuchtdiode (23) ausgebildet ist.

6. Vorrichtung nach Anspruch 2 oder einem der folgenden,
dadurch gekennzeichnet,
daß die beiden Aufnahmen (5a,5b) für zwei Kabeladern in Längsrichtung des Gehäuses (2a) hintereinander versetzt angeordnet sind.

7. Vorrichtung nach Anspruch 2 oder einem der folgenden,
dadurch gekennzeichnet,
daß die zwei Andruckelemente (16a,16b) von individuell zugeordneten Andruckfedern (20a,20b) beaufschlagt sind, während die beiden Perforationsnadeln (15a,15b) von einer einen gemeinsamen Druckstift (9a) beaufschlagenden Feder (19a) beaufschlagt werden.

8. Vorrichtung (1) zur Erzeugung eines elektrisch leitenden Kontaktes an einer isolierten Kabelader (33), mit wenigstens einer von einer ersten Feder (53) beaufschlagten, in einem Gehäuse (30) geführten, elektrisch leitenden Perforationsnadel (52) zur Durchdringung des Isoliermantels der Kabelader (33), wobei das eine Ende (31) des Gehäuses (30) mit einer Aufnahme (32) für zu kontaktierende Kabeladern unterschiedlicher Durchmesser ausgerüstet ist und dieses Ende (31) im Bereich der Aufnahme (32) kegel- oder pyramidenförmig ausgebildet ist, wobei die Perforationsnadel (52) von einemim wesentlichen hohlzylinderförmigen, im Gehäuse (30) verschiebbar angeordneten Andruckelement (42) umgeben ist, und mit einer weiteren Feder (51),
dadurch gekennzeichnet,
daß die Perforationsnadel (52) in Durchdringungsrichtung der Kabelader (33) und das Andruckelement (42) von der weiteren Feder (51) jeweils in Anpreßrichtung auf die Kabelader (33) beaufschlagt sind und
daß das Gehäuse (30) an seinem der Aufnahme (32) abgewandten Ende mit radial kompressiblen Teilen (38,39) versehen ist, deren Betätigung eine axiale Verschiebung eines die Perforationsnadel (52) tragenden Druckkolbens (35) und des diesen umgebenden Andruckelementes (42) in Richtung von der zu beaufschlagenden Kabelader (33) fort bewirkt.

9. Vorrichtung nach Anspruch 8,
dadurch gekennzeichnet,
daß die radial kompressiblen Teile von zwei diametral am Gehäuse (30) angeordneten Klemmbacken (39) mit konischen Klemmflächen (38) gebildet sind, die mit entsprechenden konischen Flächen (37) an dem Druckbolzen (35) im Sinne einer axialen Verschiebung des letzteren zusammenwirken.

10. Vorrichtung nach Anspruch 8 oder 9,
dadurch gekennzeichnet,
daß der mit der Perforationsnadel (52) verbundene, gegenüber dem Andruckelement (42) gleitbar angeordnete Druckkolben (35) mit einem axial gerichteten Anschluß für ein Kontaktkabel versehen ist.

11. Vorrichtung nach Anspruch 8 oder einem der folgenden,
dadurch gekennzeichnet,
daß der Druckkolben (35) eine zylindrische Hülse (41) aufweist, zwischen welcher und dem zentrischen Teil (40) des Druckkolbens (35) das Andruckelement (42) in Grenzen axial verschiebbar angeordnet ist.

12. Vorrichtung nach Anspruch 11,
dadurch gekennzeichnet,
daß zwischen einer Ringschulter (46) des Gehäuses (30) und einer nach außen weisenden Ringschulter (45) der zylindrischen Hülse (41) eine Spiraldruckfeder (48) angeordnet ist.

13. Vorrichtung nach Anspruch 11 und 12,
dadurch gekennzeichnet,
daß zwischen einer Ringschulter (49) des Druckkolbens (35) und einer Ringschulter (50) des Andruckelementes (42) die als Spiraldruckfeder (51) ausgebildete weitere Feder angeordnet ist.

14. Vorrichtung insbesondere nach Anspruch 8,
dadurch gekennzeichnet,
daß zwischen Druckkolben (35) und Perforationsnadel (52) die erste Feder (53) angeordnet ist, die eine nur von ihrer Stärke abhängende Perforationskraft auf die zu kontaktierende Kabelader (33) ausübt.

Claims

1. A device (1) for producing an electrically conductive contact on an insulated cable wire (21) comprising an electrically conductive first perforation needle (15) which is guided in a housing (2) and which is acted upon by a first spring (19), for penetrating the insulating sheathing of the cable wire (21), wherein the one end (3) of the housing (2) is provided with a first receiving means (5) for cable wires of different diameters to be contacted and said end (3) is of a conical or pyramid configuration in the region of the first receiving means ( 5 ), wherein the first perforation needle (15) is surrounded by a substantially hollow-cylindrical first pressing element (16) which is disposed displaceably in the housing (2), and including a further spring (20), characterised in that the first perforation needle (15), is loaded in the direction of penetration of the cable wire (21) and the first pressing element (16) is respectively loaded by the further spring (20) in the direction of pressing on to the cable wire (21), wherein provided in the housing (2) which is of a hollow-cylindrical configuration is a central pressure pin (9) and a return handle (10) guided displaceably thereon, the first perforation needle (15) being operatively connected to the shank (11) of the return handle (10).

2. A device according to claim 1 characterised in that arranged within a common housing (2a) are at least two pressing elements (16a, 16b), two receiving means (5a, 5b) and two perforation needles (15a, 15b).

3. A device according to claim 1 or claim 2 characterised in that the first perforation needle (15) or the first and second perforation needles (15a, 15b) and the first pressing element (16) or the first and second pressing elements (16, 42; 16a, 16b) are guided in the housing (20) in such a way that upon release of said parts of the device in the direction towards the respectively inserted cable wire or wires (21), firstly the respective pressing element and thereafter the perforation needle or needles are moved in the forward drive direction.

4. A device according to claim 1, claim 2 or claim 3 characterised in that the return handle (10) is displaceably guided on the stationary central pressure pin (9) within the housing (2).

5. A device according to claim 1 or one of the following claims characterised in that the indicating unit which indicates contacting between the first perforation needle (15) and the conductor of the cable wire (21) is in the form of a light emitting diode (23) arranged on the return handle (10).

6. A device according to claim 2 or one of the following claims characterised in that the two receiving means (5a, 5b) for two cable wires are arranged in displaced relationship one behind the other in the longitudinal direction of the housing (2a).

7. A device according to claim 2 or one of the following claims characterised in that the two pressing elements (16a, 16b) are acted upon by individually associated pressing springs (20a, 20b) while the two perforation needles (15a, 15b) are acted upon by a spring (19a) which acts on a common pressure pin (9a).

8. A device (1) for producing an electrically conductive contact on an insulated cable wire (33), comprising at least one electrically conductive perforation needle (52) which is guided in a housing (30) and which is acted upon by a first spring (53), for penetrating the insulating sheathing of the cable wire (33), wherein the one end (31) of the housing (30) is provided with a receiving means (32) for cable wires of different diameters to be contacted, and said end (31) is of a conical or pyramid configuration in the region of the receiving means (32), wherein the perforation needle (52) is surrounded by a substantially hollow-cylindrical pressing element (42) which is disposed displaceably in the housing (30), and including a further spring (51), characterised in that the perforation needle (52) is loaded in the direction of penetration of the cable wire (33) and the pressing element (42) is respectively loaded by the further spring (51) in the direction of pressing on to the cable wire (33) and that the housing (30) is provided at its end remote from the receiving means (32) with radially compressible portions (38, 39), the actuation of which causes axial displacement of a pressure piston (35) carrying the perforation needle (52) and the pressing element (42) surrounding the pressure piston, in a direction away from the cable wire (33) to be acted upon.

9. A device according to claim 8 characterised in that the radially compressible portions are formed by two clamping jaws (39) which are arranged diametrally on the housing (30), with conical clamping surfaces (38) which co-operate with corresponding conical surfaces (37) on the pressure pin member (34) to produce axial displacement of the latter.

10. A device according to claim 8 or claim 9 characterised in that the pressure piston (35) which is connected to the perforation needle (52) and which is arranged slidably relative to the pressing element (42) is provided with an axially directed connection for a contact cable.

11. A device according to claim 8 or one of the following claims characterised in that the pressure piston (35) has a cylindrical sleeve (41) between which and the central portion (40) of the pressure piston (35) the pressing element (42) is arranged axially slidably within limits.

12. A device according to claim 11 characterised in that a coil compression spring (48) is arranged between an annular shoulder (46) of the housing (30) and an outwardly facing annular shoulder (45) on the cylindrical sleeve (41).

13. A device according to claim 11 or claim 12 characterised in that the further spring which is in the form of a coil compression spring (51) is arranged between an annular shoulder (49) on the pressure piston (35) and an annular shoulder (50) on the pressing element (42).

14. A device in particular according to claim 8 characterised in that arranged between the pressure piston (35) and the perforation needle (52) is the first spring (53) which applies to the cable wire (33) to be contacted a perforation force which is dependent only on the strength of the spring.

## Revendications

1. Dispositif (1) pour établir un contact électroconducteur avec l'âme (21) d'un câble isolé, comprenant au moins une aiguille de perforation (15) électroconductrice soumise à l'action d'un premier ressort (19) et guidée dans un boîtier (2), destinée à traverser l'enveloppe isolante de l'âme (21) du câble, une extrémité (3) du boîtier (2) comportant un premier évidement (5) destiné à des âmes de câbles de diamètres divers avec lesquelles doit être établi un contact, et cette extrémité (3) étant constituée dans la région du premier évidement (5) sous une forme conique ou pyramidale, la première aiguille de perforation (15) étant entourée par un élément presseur (16) de forme sensiblement cylindrique et creuse et monté mobile dans le boîtier (2), et comprenant un autre ressort (2a),
caractérisé en ce que
la première aiguille de perforation (15) est sollicitée dans la direction de la perforation de l'âme (21) du câble et le premier élément presseur (16) est respectivement sollicité dans direction de la compression de l'âme (21) du câble par l'autre ressort (26), en prévoyant dans le boîtier (2) de constitution cylindrique et creuse une tige de pression (9) centrale et une poignée de recul (10) guidée sur elle de façon mobile, avec la tige (11) de laquelle la première aiguille de perforation (15) est reliée de façon fonctionnelle.

2. Dispositif selon la revendication 1, caractérisé en ce que sont disposés à l'intérieur d'un boîtier commun (2a) au moins deux éléments presseurs (16a, 16b), deux évidements (5a, 5b) et deux aiguilles de perforation (15a, 15b).

3. Dispositif selon la revendication 1 ou 2, caractérisé en ce que la première aiguille de perforation (15) ou la première et la seconde aiguilles de perforation (15a, 15b) et le premier élément presseur (16) ou le premier et le second éléments presseurs (16, 42; 16a, 16b) sont guidés dans le boîtier (30) de manière que lorsque ces éléments du dispositif sont libérés en direction de l'âme (21) du câble ou des âmes (21) des câbles en position, ce soit d'abord l'élément presseur concerné qui soit déplacé en direction de l'avance, et ensuite la ou les aiguilles de perforation.

4. Dispositif selon l'une quelconque des revendications 1 à 3, caractérisé en ce que la poignée de recul (10) est montée mobile à l'intérieur du boîtier (2) sur la tige de pression centrale et fixe (9).

5. Dispositif selon la revendication 1 ou l'une quelconque des revendications suivantes, caractérisé en ce que l'unité indicatrice qui indique qu'il y a un contact entre la première aiguille de perforation (15) et le conducteur de l'âme (21) du câble est constituée sous forme d'une diode luminescente (23) montée sur la poignée de rappel (10).

6. Dispositif selon la revendication 2 ou l'une quelconque des revendications suivantes, caractérisé en ce que les deux évidements (5a, 5b) destinés aux deux âmes de câbles sont décalés à l'arrière l'un de l'autre en direction longitudinale du boîtier (2a).

7. Dispositif selon la revendication 2 ou l'une quelconque des revendications suivantes, caractérisé en ce que les deux éléments presseurs (16a, 16b) sont soumis à l'action de ressorts de compression (20a, 20b) qui leur sont associés individuellement, alors que les deux aiguilles de perforation (15a, 15b) sont soumises à l'action d'un ressort (19a) exerçant son action sur une tige de pression (9a) commune.

8. Dispositif (1) pour établir un contact électroconducteur avec l'âme isolée (33) d'un câble, comprenant au moins une aiguille de perforation (52) électroconductrice, guidée dans un boîtier (30) et soumise à l'action d'un premier ressort (53), destinée à traverser l'enveloppe isolante de l'âme (33) du câble, une extrémité (31) du boîtier (30) étant munie d'un évidement (32) destiné à des âmes de câbles de diamètres différents avec lesquelles un contact doit être établi, et cette extrémité (31) étant constituée dans les régions de l'évidement (32) sous une forme conique ou pyramidale, l'aiguille de perforation (52) étant entourée par un élément presseur (42) monté mobile dans le boîtier (30) et de forme sensiblement cylindrique et creuse, et par un autre ressort (51),
caractérisé en ce que
l'aiguille de perforation (52) est poussée en direction de la perforation de l'âme (33) du câble et l'élément presseur (42) est respectivement sollicité par l'autre ressort (51) en direction de la pression sur l'âme (33) du câble, et en ce que le boîtier (30) est muni sur son extrémité qui est à l'opposé de l'évidement (32) d'éléments (38, 39) compressibles en direction radiale, dont l'actionnement détermine un déplacement axial d'un piston presseur (35) supportant l'aiguille de perforation (52) et de l'élément presseur (42) entourant ce dernier, en direction de l'âme (33) du câble soumise à la pression.

9. Dispositif selon la revendication 8,
caractérisé en ce que les parties compressibles en direction radiale sont formées par deux mâchoires de serrage (39) à surfaces de serrage coniques (38) disposées diamétralement dans le boîtier (30), surfaces qui coopèrent avec des surfaces coniques correspondantes (37) du tourillon de pression (35) dans le sens d'un déplacement axial de ce dernier.

10. Dispositif selon la revendication 8 ou 9,
caractérisé en ce que le piston presseur (35) relié à l'aiguille de perforation (52) et pouvant glisser par rapport à l'élément presseur (42) est muni d'un raccord orienté axialement pour un câble de contact.

11. Dispositif selon la revendication 8 ou l'une quelconque des revendications suivantes,
caractérisé en ce que le piston presseur (35) comprend une enveloppe cylindrique (41) entre laquelle et la partie centrale (40) du piston presseur (35) l'élément presseur (42) est monté axialement mobile à l'intérieur de certaines limites.

12. Dispositif selon la revendication 11,
caractérisé en ce qu'un ressort de compression hélicoïdal (48) est disposé entre un épaulement annulaire (46) du boîtier (30) et un épaulement annulaire (45) tourné vers l'extérieur du fût cylindrique (41).

13. Dispositif selon la revendication 11 ou 12,
caractérisé en ce que l'autre ressort constitué sous forme d'un ressort de compression hélicoïdal (51) est disposé entre un épaulement annulaire (49) du piston presseur (35) et un épaulement annulaire (50) de l'élément presseur (42).

14. Dispositif selon la revendication 8,
caractérisé en ce que le premier ressort (53) est disposé entre le piston presseur (35) et l'aiguille de perforation (52), et exerce sur l'âme (33) du câble avec laquelle le contact doit être établi une force de perforation qui ne dépend que de sa force.

FIG. 1

FIG. 2

FIG. 3

FIG. 4

FIG. 5

FIG. 6

FIG. 7